# EUROPEAN PATENT APPLICATION

(11) **EP 4 539 645 A1**
(43) Date of publication of application: **16.04.2025**
(21) Application number: 24203053.4
(22) Date of filing: 26.09.2024
(51) Int. Cl.: H10K 59/122, H10K 59/80

(54) **DISPLAY PANEL AND METHOD OF MANUFACTURING THE SAME**

(30) Priority: 10.10.2023 KR 20230134158
(71) Applicant: Samsung Display Co., Ltd., Gyeonggi-Do (KR)
(72) Inventor: YANG, Hee Jun, Yongin-si (KR); SUNG, Woo Yong, Yongin-si (KR); LEE, Yonghan, Yongin-si (KR); LEE, Jeongseok, Yongin-si (KR)
(74) Representative: Marks & Clerk LLP

(57) **Abstract**

A display panel (DP) includes a base layer (BL), a pixel defining film (PDL) disposed on the base layer and having a light emitting opening(OP-E), a partition wall including a first partition wall layer (L1) disposed on the pixel defining film (PDL) and a second partition wall layer (L2) disposed on the first partition wall layer (L1), where a partition wall opening (OP-P) is defined in the partition wall to overlap the light emitting opening (OP-E), and a light emitting element (ED) including an anode (AE), an intermediate layer (EP), and a cathode (CE) in contact with the partition wall, where at least a portion of the light emitting element (ED) is disposed inside the partition wall opening (OP-P), where a first inner surface (S-L1) of the first partition wall layer (L1) and a second inner surface (S-L2) of the second partition wall layer (L2) are aligned with each other.

## Description

### BACKGROUND

### 1. Field

Embodiments of the disclosure relate to a display panel and a method of manufacturing the display panel, and more particularly, a display panel having improved display quality.

### 2. Description of the Related Art

Display devices such as televisions, monitors, smart phones, and tablet personal computers (PCs) that provide images to users may include display panels that display images. Various display panels such as liquid crystal display panels, organic light emitting display panels, electro wetting display panels, and electrophoretic display panels have been developed as the display panels.

The organic light emitting display panel may include an anode, a cathode, and a light emitting pattern. The light emitting pattern may be separated for each of light emitting areas, and the cathode may provide a common voltage to each of the light emitting areas.

### SUMMARY

Embodiments of the disclosure provide a display panel provided by forming a light emitting element without using a metal mask and having improved display quality, and a method of manufacturing the same.

According to an embodiment, a display panel includes a base layer, a pixel defining film disposed on the base layer, where a light emitting opening is defined in the pixel defining film, a partition wall including a first partition wall layer disposed on the pixel defining film and a second partition wall layer disposed on the first partition wall layer, where a partition wall opening is defined in the partition wall to overlap the light emitting opening, and a light emitting element including an anode, an intermediate layer, and a cathode in contact with the partition wall, where at least a portion of the light emitting element is disposed inside the partition wall opening, and a first inner surface of the first partition wall layer and a second inner surface of the second partition wall layer are aligned with each other.

In an embodiment, the second partition wall layer may include an inorganic material.

In an embodiment, the second partition wall layer may include at least one selected from SiON and SiNₓ.

In an embodiment, the display panel may further include a plurality of light emitting areas from which lights provided from the light emitting element are emitted, wherein the cathode is disconnected by the partition wall to correspond to the plurality of light emitting areas.

In an embodiment, the display panel may further include a lower encapsulation inorganic pattern covering the light emitting element, where the lower encapsulation inorganic pattern may be disposed inside the partition wall opening.

In an embodiment, a side surface of the lower encapsulation inorganic pattern may be in contact with the second inner surface of the second partition wall layer.

In an embodiment, the display panel may further include an encapsulation organic film disposed on the lower encapsulation inorganic pattern, where the encapsulation organic film may cover an upper surface of the second partition wall layer and an upper surface of the lower encapsulation inorganic pattern.

In an embodiment, the cathode may extend along the first inner surface of the first partition wall layer, and an end portion of the cathode may be in contact with the first partition wall layer.

In an embodiment, a width of the partition wall opening may be constant along the first partition wall layer and the second partition wall layer.

According to an embodiment, a method of manufacturing a display panel includes providing a preliminary display panel in which a base layer, an anode, a pixel defining film, a first preliminary partition wall layer, and a second preliminary partition wall layer are sequentially laminated, forming a third preliminary partition wall layer and a fourth preliminary partition wall layer on the first preliminary partition wall layer and the second preliminary partition wall layer, forming a preliminary partition wall including a tip portion and defining a preliminary partition wall opening by etching the first to fourth preliminary partition wall layers, forming a light emitting pattern and a cathode on the anode, forming a preliminary lower encapsulation inorganic pattern on the cathode, and forming a partition wall and a lower encapsulation inorganic pattern by etching the preliminary lower encapsulation inorganic pattern, the third preliminary partition wall layer, and the fourth preliminary partition wall layer.

In an embodiment, the method may further include etching a portion of the second preliminary partition wall layer, which corresponds to the anode.

In an embodiment, the forming the preliminary partition wall including the tip portion and defining the preliminary partition wall opening by etching the first to fourth preliminary partition wall layers may include forming a first preliminary partition wall opening by etching the first preliminary partition wall layer, the third preliminary partition wall layer, and the fourth preliminary partition wall layer, and forming a second preliminary partition wall opening by etching the first to third preliminary partition wall layers.

In an embodiment, the second preliminary partition wall opening may include a first area defined by an inner surface of the first preliminary partition wall layer, an inner surface of the second preliminary partition wall layer, and an inner surface of the third preliminary partition wall layer, and a second area defined by an inner surface of the fourth preliminary partition wall layer, and a width of the second area may be less than a width of the first area.

In an embodiment, an etched fourth preliminary partition wall layer may define the tip portion.

In an embodiment, the forming the light emitting pattern and the cathode on the anode may include forming, on the preliminary partition wall, a first dummy pattern including a same material as a material of the light emitting pattern and a second dummy pattern including a same material as a material of the cathode.

In an embodiment, the forming the preliminary lower encapsulation inorganic pattern on the cathode may include forming a lower encapsulation inorganic layer to cover the cathode and the preliminary partition wall, and etching a portion of the lower encapsulation inorganic layer, which does not overlap the anode.

In an embodiment, the method may further include etching the first dummy pattern and the second dummy pattern.

In an embodiment, the forming the partition wall and the lower encapsulation inorganic pattern by etching the preliminary lower encapsulation inorganic pattern, the third preliminary partition wall layer, and the fourth preliminary partition wall layer may include etching the third preliminary partition wall layer and the fourth preliminary partition wall layer, where a first partition wall layer included in the partition wall is formed from the first preliminary partition wall layer and a second partition wall layer included in the partition wall is formed from the second preliminary partition wall layer.

In an embodiment, the forming the partition wall and the lower encapsulation inorganic pattern by etching the preliminary lower encapsulation inorganic pattern, the third preliminary partition wall layer, and the fourth preliminary partition wall layer may further include etching the preliminary lower encapsulation inorganic pattern overlapping the third preliminary partition wall layer and the fourth preliminary partition wall layer, where a side surface of the lower encapsulation inorganic pattern is in contact with an inner surface of the second partition wall layer.

According to an embodiment, a display panel includes a base layer, a pixel defining film disposed on the base layer, where a light emitting opening is defined in the pixel defining film, a partition wall including a first partition wall layer disposed on the pixel defining film and a second partition wall layer disposed on the first partition wall layer, where a partition wall opening is defined in the partition wall to overlap the light emitting opening, a light emitting element including an anode, an intermediate layer, and a cathode in contact with the partition wall, where at least a portion of the light emitting element is disposed inside the partition wall opening, and a lower encapsulation inorganic pattern covering the light emitting element and disposed in the partition wall opening, where the lower encapsulation inorganic pattern does not overlap the partition wall in a thickness direction of the base layer.

At least some of the above and other features of the invention are set out in the claims.

### BRIEF DESCRIPTION OF THE DRAWINGS

The above and other features of embodiments of the disclosure will become apparent by describing in detail embodiments thereof with reference to the accompanying drawings, in which:
FIG. 1A is a perspective view of a display device according to an embodiment of the disclosure;
FIG. 1B is an exploded perspective view of the display device according to an embodiment of the disclosure;
FIG. 2 is a cross-sectional view of a display module according to an embodiment of the disclosure;
FIG. 3 is a plan view of a display panel according to an embodiment of the disclosure;
FIG. 4 is an enlarged plan view of a portion of a display area of the display panel according to an embodiment of the disclosure;
FIG. 5 is a cross-sectional view of the display panel taken along line I-I' of FIG. 3 according to an embodiment of the disclosure;
FIG. 6 is a cross-sectional view taken along line II-II' of FIG. 4; and
FIGS. 7A to 7L are cross-sectional views illustrating some of operations of a method of manufacturing the display panel according to an embodiment of the disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

It will be understood that when an element is referred to as being "on" another element, it can be directly on the other element or intervening elements may be present therebetween. In contrast, when an element is referred to as being "directly on" another element, there are no intervening elements present.

In the specification, the expression that a first component (or area, layer, part, portion, etc.) is "on", "connected with", or "coupled to" a second component means that the first component is directly on, connected with, or coupled to the second component or means that a third component is interposed therebetween.

The same reference numerals refer to the same components. Further, in the drawings, the thickness, the ratio, and the dimension of components are exaggerated for effective description of technical contents. The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items.

Although the terms "first", "second", etc. may be used to describe various components, the components should not be limited by the terms. The terms are only used to distinguish one component from another component. For example, without departing from the right scope of the disclosure, a first component may be referred to as a second component, and similarly, the second component may be also referred to as the first component. Singular expressions include plural expressions unless clearly otherwise indicated in the context.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

It will be understood that the terms "comprises" and/or "comprising," or "includes" and/or "including" when used in this specification, specify the presence of features, numbers, steps, operations, elements, or components, described in the specification, or a combination thereof, and do not exclude in advance the presence or additional possibility of one or more other features, numbers, steps, operations, elements, or components or a combination thereof.

"About" or "approximately" as used herein are inclusive of the stated value and mean within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical terms and scientific terms) used in the specification have the same meaning as commonly understood by those skilled in the art to which the disclosure belongs. Furthermore, terms such as terms defined in the dictionaries commonly used should be interpreted as having a meaning consistent with the meaning in the context of the related technology, and should not be interpreted in overly ideal or overly formal meanings unless explicitly defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the disclosure will be described with reference to the accompanying drawings.

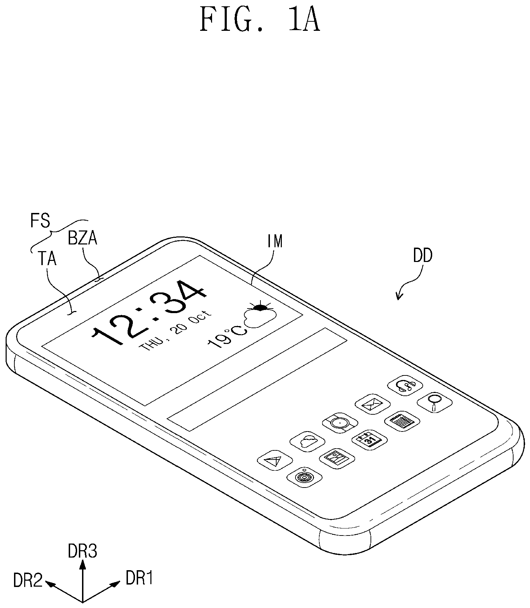

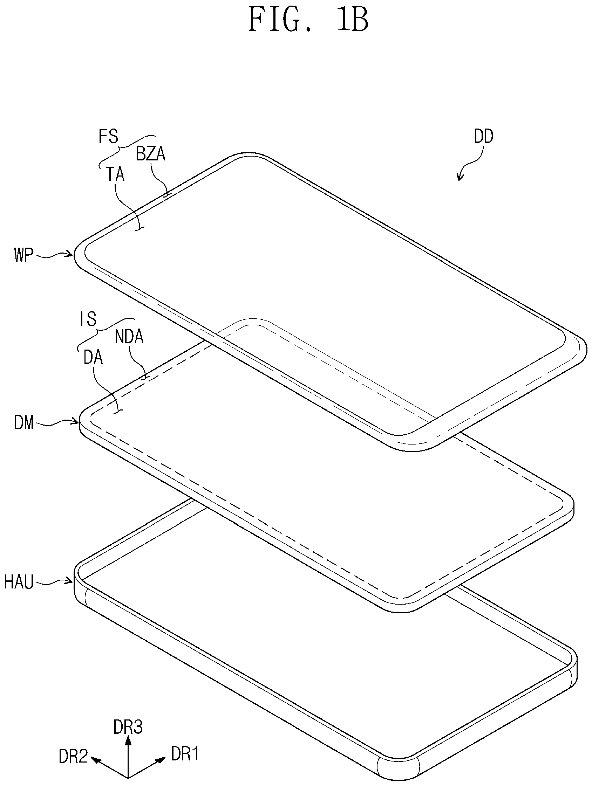

FIG. 1A is a perspective view of a display device DD according to an embodiment of the disclosure, and FIG. 1B is an exploded perspective view of the display device DD according to an embodiment of the disclosure.

In an embodiment, the display device DD may be a large electronic device such as a television, a monitor, or an external billboard. In an embodiment, the display device DD may be a small or medium-sized electronic device such as a personal computer (PC), a laptop, a personal digital terminal, a vehicle navigation unit, a game console, a smart phone, a tablet PC, and a camera. However, this is illustrative, and other display devices may be adopted as long as the display devices do not deviate from the concept of the disclosure. FIGS. 1A and 1B illustrate an embodiment where the display device DD is a smart phone.

Referring to FIGS. 1A and 1B, an embodiment of the display device DD may display an image IM in a third direction DR3 on a display surface FS parallel to a first direction DR1 and a second direction DR2. The third direction DR3 may be a normal direction of a plane defined by the first direction DR1 and the second direction DR2. The third direction DR3 may be a thickness direction of the display device DD. The image IM may include a still image as well as a dynamic image. In an embodiment, as shown in FIG. 1A, the image IM may include a watch window and icons, for example. The display surface FS on which the image IM is displayed may correspond to a front surface of the display device DD.

In an embodiment, a front surface (or an upper surface) and a rear surface (or a lower surface) of each member are defined with respect to a direction, in which the image IM is displayed. The front surface and the rear surface may face each other in the third direction DR3, and a normal direction of each of the front and rear surfaces may be parallel to the third direction DR3. Here, directions indicated by the first to third directions DR1, DR2, and DR3 are relative concepts and may be changed to other directions. In the specification, a phrase of "on a plane" or "in a plan view" may mean a state when viewed in the third direction DR3.

The display device DD may include a window WP, a display module DM, and a housing HAU. The window WP and the housing HAU may be coupled to each other to constitute an exterior of the display device DD.

The window WP may include an optically transparent insulating material. In an embodiment, for example, the window WP may include a glass or plastic. A front surface of the window WP may define the display surface FS of the display device DD. The display surface FS may include a transmissive area TA and a bezel area BZA. The transmissive area TA may be an optically transparent area. In an embodiment, for example, the transmissive area TA may be an area having a visible light transmittance of about 90% or greater.

The bezel area BZA may be an area having a relatively lower light transmittance than that of the transmissive area TA. The bezel area BZA may define a shape of the transmissive area TA. The bezel area BZA may be adjacent to the transmissive area TA and surround the transmissive area TA. However, this is illustrative, and the bezel area BZA of the window WP may be omitted. The window WP may include at least one functional layer selected from a fingerprint preventing layer, a hard coating layer, and a reflection preventing layer, and is not limited to an embodiment.

The display module DM may be disposed under the window WP. The display module DM may be a component that substantially generates the image IM. The image IM generated by the display module DM is displayed on a display surface IS of the display module DM and is visually recognized by a user from the outside through the transmissive area TA.

The display module DM may include a display area DA and a non-display area NDA. The display area DA may be an area that is activated based on an electric signal. The non-display area NDA may be adjacent to the display area DA. The non-display area NDA may surround the display area DA. The non-display area NDA is an area covered by the bezel area BZA and may not be visually recognized from the outside.

The housing HAU may be coupled to the window WP. The housing HAU may be coupled to the window WP to provide a predetermined inner space. The display module DM may be accommodated in the inner space.

The housing HAU may include a material having a relatively high rigidity. In an embodiment, for example, the housing HAU may include a plurality of frames and/or plates including a glass, a plastic, a metal or a combination thereof. The housing HAU may stably protect components of the display device DD accommodated in the inner space from an external impact.

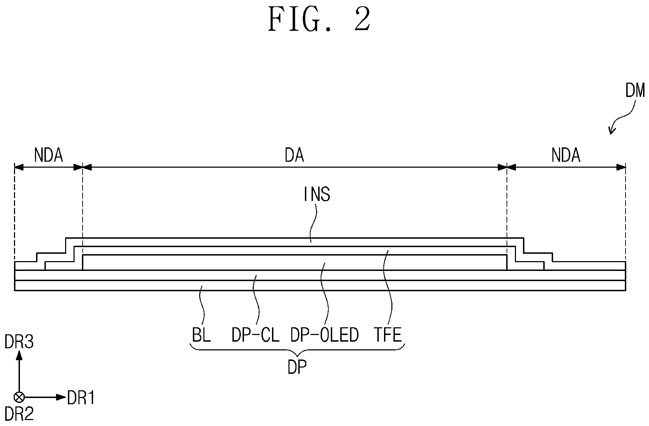

FIG. 2 is a cross-sectional view of the display module DM according to an embodiment of the disclosure.

Referring to FIG. 2, an embodiment of the display module DM may include a display panel DP and an input sensor INS. Although not separately illustrated, the display device DD (see FIG. 1A) according to an embodiment of the disclosure may further include a reflection preventing member and/or a window member disposed on an upper surface of a protective member or the input sensor INS disposed on a lower surface of the display panel DP.

The display panel DP may be a light emitting display panel. However, this is illustrative, and the disclosure is not particularly limited thereto. In an embodiment, for example, the display panel DP may be an organic light emitting display panel or an inorganic light emitting display panel. A light emitting layer in the organic light emitting display panel may include an organic light emitting material. A light emitting layer in the inorganic light emitting display panel may include a quantum dot, a quantum rod, or a micro light emitting diode (LED). Hereinafter, for convenience of description, embodiments where the display panel DP is the organic light emitting display panel will be described in detail.

The display panel DP may include a base layer BL, and a circuit element layer DP-CL, a display element layer DP-OLED, and a thin film encapsulation layer TFE which are arranged on the base layer BL. The input sensor INS may be directly disposed on the thin film encapsulation layer TFE. In the specification, the wording "component A is directly disposed on component B" means that no adhesive layer is disposed between component A and component B.

The base layer BL may include at least one plastic film. The base layer BL is a flexible substrate and may include a plastic substrate, a glass substrate, a metal substrate, or an organic/inorganic composite material substrate. The display area DA and the non-display area NDA described above with reference to FIG. 1B may be defined on the base layer BL in the same manner.

The circuit element layer DP-CL may include at least one insulating layer and a circuit element. The insulating layer includes at least one inorganic layer and at least one organic layer. The circuit element includes signal lines, a driving circuit of a pixel, or the like.

The display element layer DP-OLED may include a partition wall and a light emitting element. The light emitting element may include an anode, an intermediate layer, and a cathode.

The thin film encapsulation layer TFE may include a plurality of thin films. At least one selected from the thin films may be arranged to improve optical efficiency, and at least one selected from the thin films may be arranged to protect organic light emitting diodes.

The input sensor INS acquires coordinate information of an external input. The input sensor INS may have a multilayer structure. The input sensor INS may include a single-layered or multi-layered conductive layer. Further, the input sensor INS may include a single layered or multi-layered insulating layer. The input sensor INS may detect an external input in a capacitive manner. However, this is illustrative, and the disclosure is not limited thereto. For example, in an embodiment, the input sensor INS may also detect an external input in an electromagnetic induction manner or a pressure sensing manner. In another embodiment of the disclosure, the input sensor INS may be omitted.

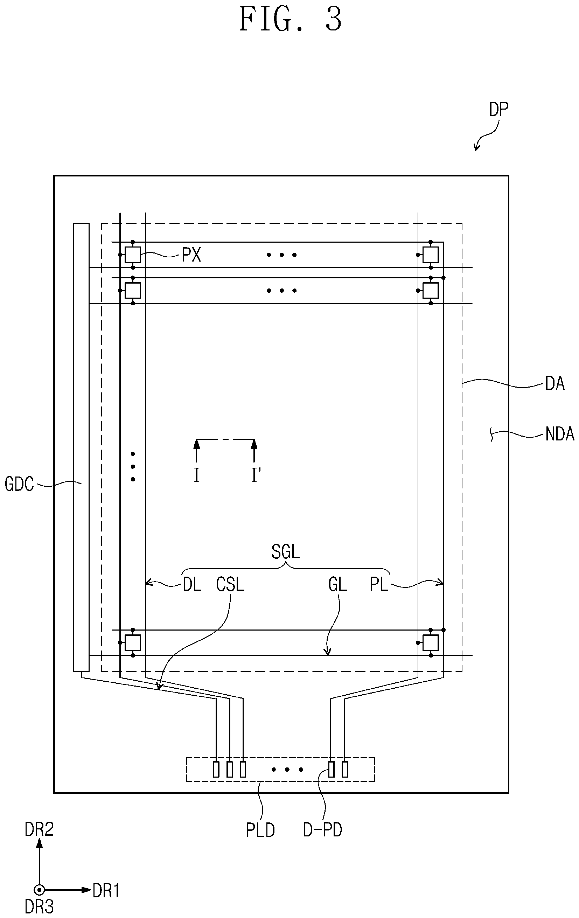

FIG. 3 is a plan view of a display panel DP according to an embodiment of the disclosure.

Referring to FIG. 3, an embodiment of the display panel DP may include the display area DA and the non-display area NDA around the display area DA. The display panel DP may include pixels PX and signal lines SGL electrically connected to the pixels PX. The display panel DP may include a driving circuit GDC and a pad part PLD. The display area DA and the non-display area NDA may be distinguished depending on whether the pixel PX is disposed. The pixel PX may be disposed in the display area DA. The driving circuit GDC and the pad part PLD may be arranged in the non-display area NDA.

The pixels PX may be arranged in the first direction DR1 and the second direction DR2. The pixels PX may include a plurality of pixel rows extending in the first direction DR1 and arranged in the second direction DR2 and a plurality of pixel columns extending in the second direction DR2 and arranged in the first direction DR1.

The signal lines SGL may include gate lines GL, data lines DL, a power line PL, and a control signal line CSL. Each of the gate lines GL may be connected to a corresponding pixel among the pixels PX, and each of the data lines DL may be connected to a corresponding pixel among the pixels PX. The power line PL may be electrically connected to the pixels PX. The control signal line CSL may be connected to the driving circuit GDC to provide control signals to the driving circuit GDC.

The driving circuit GDC may include a gate driving circuit. The gate driving circuit may generate gate signals and sequentially output the generated gate signal to the gate lines GL. The gate driving circuit may further output another control signal to a pixel driving circuit.

The pad part PLD may be a part to which a flexible circuit board is connected. The pad part PLD may include pixel pads D-PD, and the pixel pads D-PD may be pads for connecting the flexible circuit board to the display panel DP. Each of the pixel pads D-PD may be connected to a corresponding signal line among the signal lines SGL. The pixel pads D-PD may be connected to the corresponding pixels PX through the signal lines SGL. Further, any one pixel pad among the pixel pads D-PD may be connected to the driving circuit GDC.

In an embodiment, the pad part PLD may further include input pads. The input pads may be pads for connecting the flexible circuit board to the input sensor INS (see FIG. 2). However, the disclosure is not limited thereto, and the input pads may be arranged in the input sensor INS (see FIG. 2) and connected to a circuit board separate from the pixel pads D-PD. Alternatively, the input sensor INS (see FIG. 2) may be omitted and may not further include the input pads.

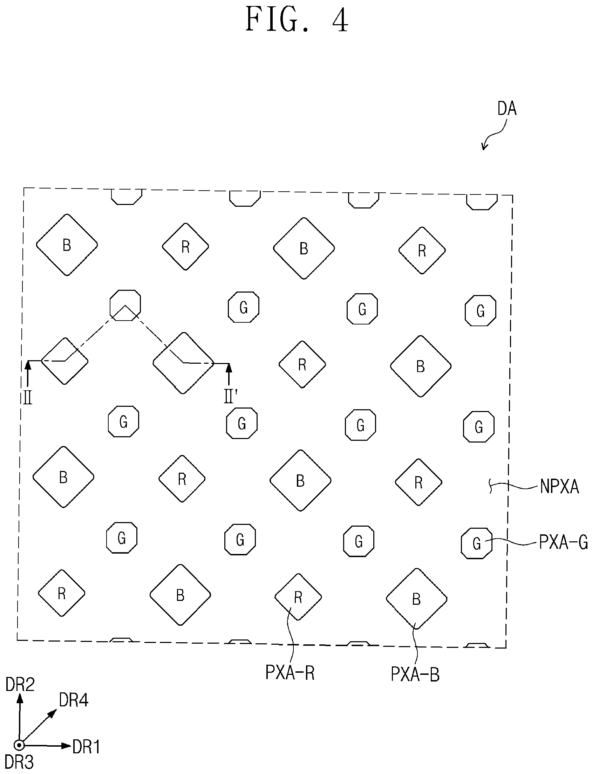

FIG. 4 is an enlarged plan view of a portion of the display area DA of the display panel DP (see FIG. 2) according to an embodiment of the disclosure. FIG. 4 illustrates a plane of the display module DM when viewed from the display surface IS (see FIG. 1B) of the display module DM (see FIG. 1B) and illustrates arrangement of light emitting areas PXA-R, PXA-G, and PXA-B.

Referring to FIG. 4, in an embodiment, the display area DA may include the first to third light emitting areas PXA-R, PXA-G, and PXA-B and a peripheral area NPXA surrounding the first to third light emitting areas PXA-R, PXA-G, and PXA-B. (hereinafter, for the convenience of explanation, the light emitting area PXA-R and the first light emitting area PXA-R indicate the same feature; the light emitting area PXA-G and the second light emitting area PXA-G indicate the same feature; and the light emitting area PXA-B and the third light emitting area PXA-B indicate the same feature; and they are not specially distinguished in the description). The first to third light emitting areas PXA-R, PXA-G, and PXA-B may respectively correspond to areas from which lights provided from the light emitting elements are emitted. The first to third light emitting areas PXA-R, PXA-G, and PXA-B may be classified based on a color of a light emitted toward the outside of the display module DM (see FIG. 2).

The first to third light emitting areas PXA-R, PXA-G, and PXA-B may provide first to third color lights having different colors, respectively. In an embodiment, for example, the first color light may be a red light, the second color light may be a green light, and the third color light may be a blue color. However, examples of the first to third color lights are not necessarily limited to the above example.

Each of the first to third light emitting areas PXA-R, PXA-G, and PXA-B may be defined as an area in which an upper surface of the anode is exposed by a light emitting opening, which will be described below. The peripheral area NPXA may set boundaries between the first to third light emitting areas PXA-R, PXA-G, and PXA-B and effectively prevent color mixing between the first to third light emitting areas PXA-R, PXA-G, and PXA-B.

The first to third light emitting areas PXA-R, PXA-G, and PXA-B may be provided such that all of the numbers thereof are plural and may be repeatedly arranged in the display area DA in a specific arrangement form. In an embodiment, for example, the first and third light emitting areas PXA-R and PXA-B may be alternately arranged in the first direction DR1 to constitute a "first group." The second light emitting areas PXA-G may be arranged in the first direction DR1 to constitute a "second group." Each of the "first group" and the "second group" may be provided in plurality, and the "first groups" and the "second groups" may be alternately arranged in the second direction DR2.

One second light emitting area PXA-G may be spaced apart from one first light emitting area PXA-R or one third light emitting area PXA-B in a fourth direction DR4. The fourth direction DR4 may be defined as a direction between the first and second directions DR1 and DR2.

FIG. 4 illustrates an arrangement form of the first to third light emitting areas PXA-R, PXA-G, and PXA-B in an embodiment, but the disclosure is not limited thereto, and the first to third light emitting areas PXA-R, PXA-G, and PXA-B may be arranged in various forms. In an embodiment, as illustrated in FIG. 4, the first to third light emitting areas PXA-R, PXA-G, and PXA-B may have a PENTILE^{™} arrangement form. Alternatively, the first to third light emitting areas PXA-R, PXA-G, and PXA-B may also have a stripe arrangement form or a diamond pixel^{™} arrangement form.

The first to third light emitting areas PXA-R, PXA-G, and PXA-B may have various shapes on a plane. In an embodiment, for example, the first to third light emitting areas PXA-R, PXA-G, and PXA-B may have shapes such as a polygonal shape, a circular shape, or an elliptic shape. FIG. 4 illustrates an embodiment where each of the first and third light emitting areas PXA-R and PXA-B has a quadrangular shape (or a diamond shape) and the second light emitting area PXA-G has an octagonal shape on a plane.

The first to third light emitting areas PXA-R, PXA-G, and PXA-B may have a same shape as each other on a plane or may have at least partially different shapes from each other. FIG. 4 illustrates an embodiment where the first and third light emitting areas PXA-R and PXA-B have a same shape as each other and the second light emitting area PXA-G has a shape different from that of the first and third light emitting areas PXA-R and PXA-B on a plane.

At least some of the first to third light emitting areas PXA-R, PXA-G, and PXA-B may have different areas on a plane. In an embodiment, an area of the first light emitting area PXA-R that emits a red light may be larger than an area of the second light emitting area PXA-G that emits a green light and may be smaller than an area of the third light emitting area PXA-B that emits a blue light. However, a size relationship between the areas of the first to third light emitting areas PXA-R, PXA-G, and PXA-B based on the colors of the emitted lights is not limited thereto and may be diversified depending on a design of the display module DM (see FIG. 2). However, the disclosure is not limited thereto, and the first to third light emitting areas PXA-R, PXA-G, and PXA-B may also have a same area as each other on a plane.

In embodiments of the disclosure, the shape, the area, the arrangement, or the like of the first to third light emitting areas PXA-R, PXA-G, and PXA-B of the display module DM (see FIG. 2) may be variously designed or modified based on the colors of the emitted lights or the size and configuration of the display module DM (see FIG. 2) and are not limited to those illustrated in FIG. 4.

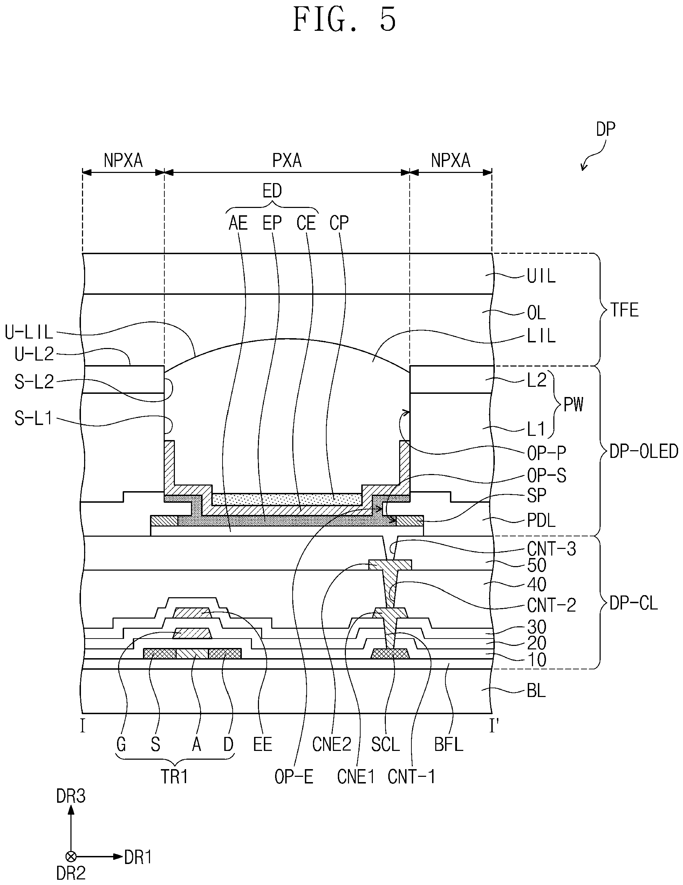

FIG. 5 is a cross-sectional view of the display panel taken along line I-I' of FIG. 3 according to an embodiment of the disclosure. The same or like elements shown in FIG. 5 have been labeled with the same reference characters as used above to describe the embodiment shown in FIG. 2, and any repetitive detailed description thereof will hereinafter be omitted or simplified. FIG. 5 illustrates an enlarged view showing a portion including only one light emitting area PXA in the display area DA (see FIG. 4), and the light emitting area PXA of FIG. 5 may correspond to one of the first to third light emitting areas PXA-R, PXA-G, and PXA-B of FIG. 4.

Referring to FIG. 5, an embodiment of the display panel DP may include the base layer BL, the circuit element layer DP-CL, the display element layer DP-OLED, and the thin film encapsulation Layer TFE.

The display panel DP may include a plurality of insulating layers, a plurality of semiconductor patterns, a plurality of conductive patterns, a plurality of signal lines, or the like. The insulating layer, the semiconductor layer, and the conductive layer are formed by coating, deposition, or the like. Thereafter, the insulating layer, the semiconductor layer, and the conductive layer may be selectively patterned by photolithography and etching. In this manner, the semiconductor pattern, the conductive pattern, the signal line, and the like included in the circuit element layer DP-CL and the display element layer DP-OLED may be formed.

The circuit element layer DP-CL may be disposed on the base layer BL. The circuit element layer DP-CL may include a buffer layer BFL, a transistor TR1, a signal transmitting area SCL, first to fifth insulating layers 10, 20, 30, 40, and 50, an electrode EE, and a plurality of connection electrodes CNE1 and CNE2.

The buffer layer BFL may be disposed on the base layer BL. The buffer layer BFL may improve a coupling force between the base layer BL and the semiconductor pattern. The buffer layer BFL may include a silicon oxide layer and a silicon nitride layer. The silicon oxide layer and the silicon nitride layer may be alternately laminated in the buffer layer BFL.

The semiconductor pattern may be disposed on the buffer layer BFL. The semiconductor pattern may include polysilicon. However, the disclosure is not limited thereto, and the semiconductor pattern may include amorphous silicon or metal oxide. FIG. 5 illustrates only a portion of the semiconductor pattern, and the semiconductor patterns may be further arranged in the plurality of light emitting areas PXA-R, PXA-G, and PXA-B (see FIG. 4). The semiconductor pattern may be arranged in a specific rule across the plurality of light emitting areas PXA-R, PXA-G, and PXA-B. The semiconductor pattern may have a different electrical property depending on whether or not the semiconductor pattern is doped. The semiconductor pattern may include a first area having a high doping concentration and a second area having a low doping concentration. The first area may be doped with an N-type dopant or a P-type dopant. A P-type transistor may include the first area doped with the P-type dopant.

A conductivity of the first area is greater than a conductivity of the second area, and the first area substantially serves as an electrode or a signal line. The second area may substantially correspond to an active (or a channel) of a transistor. In other words, a portion of the semiconductor pattern may be the active of the transistor, another portion of the semiconductor pattern may be a source or a drain of the transistor, and still another portion of the semiconductor pattern may be a conductive area.

A source "S," an active "A," and a drain "D" of the transistor TR1 may be formed from the semiconductor pattern. FIG. 5 illustrates a portion of the signal transmitting area SCL formed from the semiconductor pattern. Although not separately illustrated, the signal transmitting area SCL may be connected to the drain "D" of the transistor TR1 on a plane.

The first to fifth insulating layers 10, 20, 30, 40, and 50 may be arranged on the buffer layer BFL. Each of the first to fifth insulating layers 10, 20, 30, 40, and 50 may include an inorganic layer or an organic layer.

The first insulating layer 10 may be disposed on the buffer layer BFL. The first insulating layer 10 may cover the source "S," the active "A," and the drain "D" of the transistor TR1 and the signal transmitting area SCL arranged on the buffer layer BFL. A gate "G" of the transistor TR1 may be disposed on the first insulating layer 10. The second insulating layer 20 may be disposed on the first insulating layer 10 to cover the gate "G." The electrode EE may be disposed on the second insulating layer 20. The third insulating layer 30 may be disposed on the second insulating layer 20 to cover the electrode EE.

The first connection electrode CNE1 may be disposed on the third insulating layer 30. The first connection electrode CNE1 may be connected to the signal transmitting area SCL through a contact hole CNT-1 defined through the first to third insulating layers 10, 20, and 30. The fourth insulating layer 40 may be disposed on the third insulating layer 30 to cover the first connection electrode CNE1. The fourth insulating layer 40 may be an organic layer.

The second connection electrode CNE2 may be disposed on the fourth insulating layer 40. The second connection electrode CNE2 may be connected to the first connection electrode CNE1 through a contact hole CNT-2 defined through the fourth insulating layer 40. The fifth insulating layer 50 may be disposed on the fourth insulating layer 40 to cover the second connection electrode CNE2. The fifth insulating layer 50 may be an organic layer.

The display element layer DP-OLED may be disposed on the circuit element layer DP-CL. The display element layer DP-OLED may include a light emitting element ED, a sacrificial pattern SP, a pixel defining film PDL, and a partition wall PW.

The light emitting element ED may include an anode AE (or a first electrode), a light emitting pattern EP, and a cathode CE (or a second electrode).

The anode AE may be disposed on the fifth insulating layer 50 of the circuit element layer DP-CL. The anode AE may be a transmissive electrode, a semi-transmissive electrode, or a reflective electrode. The anode AE may be connected to the second connection electrode CNE2 through a connection contact hole CNT-3 defined through the fifth insulating layer 50. Thus, the anode AE may be electrically connected to the signal transmitting area SCL through the first and second connection electrodes CNE1 and CNE2 and thus electrically connected to the corresponding circuit element. The anode AE may include a single-layer structure or a multi-layer structure. The anode AE may include a plurality of layers including indium tin oxide (ITO) and Ag. In an embodiment, for example, the anode AE may include a layer including the ITO (hereinafter, referred to as a lower ITO layer), a layer disposed on the lower ITO layer and including Ag (hereinafter, referred to as an Ag layer), and a layer disposed on the Ag layer and including the ITO (hereinafter, referred to as an upper ITO layer).

The sacrificial pattern SP may be disposed between the anode AE and the pixel defining film PDL. A sacrificial opening OP-S, through which a portion of an upper surface of the anode AE is exposed, may be defined (or provided) in the sacrificial pattern SP. The sacrificial opening OP-S may overlap a light emitting opening OP-E, which will be described below.

The pixel defining film PDL may be disposed on the fifth insulating layer 50 of the circuit element layer DP-CL. The light emitting opening OP-E may be defined (or provided) in the pixel defining film PDL. The light emitting opening OP-E may correspond the anode AE, and the pixel defining film PDL may expose at least a portion of the anode AE through the light emitting opening OP-E.

In an embodiment, the light emitting opening OP-E may correspond to the sacrificial opening OP-S of the sacrificial pattern SP. According to an embodiment, the upper surface of the anode AE may be spaced apart from the pixel defining film PDL in a cross section with the sacrificial pattern SP interposed therebetween, and accordingly, damage to the anode AE may be effectively prevented in a process of forming the light emitting opening OP-E.

On a plane (or when viewed in the third direction DR3), an area of the light emitting opening OP-E may be smaller than an area of the sacrificial opening OPS. That is, an inner surface of the pixel defining film PDL defining the light emitting opening OP-E may be closer to a center of the anode AE than an inner surface of the sacrificial pattern SP defining the sacrificial opening OP-S. However, the disclosure is not limited thereto, and the inner surface of the sacrificial pattern SP defining the sacrificial opening OP-S may be substantially aligned (or on a same plane) with the inner surface of the pixel defining film PDL defining the light emitting opening OP-E. In such an embodiment, the light emitting area PXA may be regarded as an area of the anode AE exposed from the corresponding sacrificial opening OP-S.

The pixel defining film PDL may include an inorganic insulating material. In an embodiment, for example, the pixel defining film PDL may include a silicon nitride (SiNₓ). The pixel defining film PDL may be disposed between the anode AE and the partition wall PW and block electrical connection between the anode AE and the partition wall PW.

The light emitting pattern EP may be disposed on the anode AE. The light emitting pattern EP may include a light emitting layer including a light emitting material. The light emitting pattern EP may further include a hole injection layer (HIL) and a hole transport layer (HTL) arranged between the anode AE and the light emitting layer and may further include an electron transport layer (ETL) and an electron injection layer (EIL) arranged on the light emitting layer. The light emitting pattern EP may be referred to as an "organic layer" or an "intermediate layer."

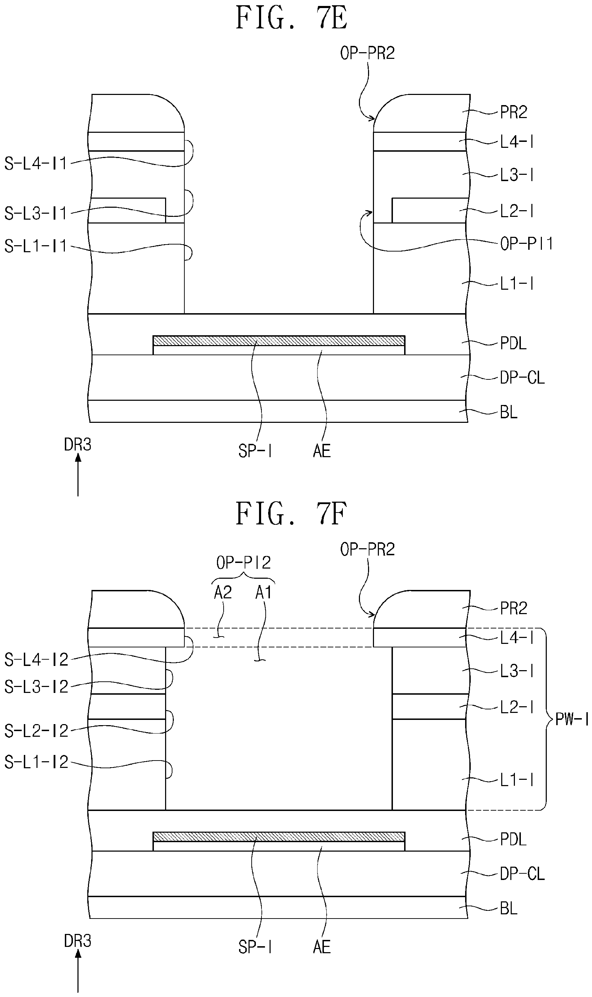

The light emitting pattern EP may be patterned by a tip portion defined in a preliminary partition wall PW-I (see FIG. 7F) formed in a display panel manufacturing process. A detailed description thereof will be made below. The light emitting pattern EP may be disposed inside the sacrificial opening OP-S and the light emitting opening OP-E. However, this is illustrative, and the light emitting pattern EP may be disposed inside at least one of the sacrificial opening OP-S, the light emitting opening OP-E, and a partition wall opening OP-P. The light emitting pattern EP may cover a portion of an upper surface of the pixel defining film PDL.

The cathode CE may be disposed on the light emitting pattern EP. The cathode CE may be patterned by a tip portion defined in the preliminary partition wall PW-I (see FIG. 7F) formed in the display panel manufacturing process. A detailed description thereof will be made below. At least a portion of the cathode CE may be disposed in the partition wall opening OP-P. FIG. 5 illustrates an embodiment where the cathode CE is disposed inside the light emitting opening OP-E and the partition wall opening OP-P, but the disclosure is not limited thereto. In an embodiment, for example, the cathode CE may be disposed only inside the partition wall opening OP-P.

The cathode CE may extend along a first inner surface S-L1 of a first partition wall layer L1, and an end portion of the cathode CE may be in contact with the first partition wall layer L1. At least a portion of the cathode CE may be in contact with the first inner surface S-L1 of the first partition wall layer L1. FIG. 5 illustrates an embodiment where the cathode CE is in contact with the first inner surface S-L1 of the first partition wall layer L1 and the inner surface of the pixel defining film PDL, but the disclosure is not limited thereto. In an embodiment, for example, the cathode CE may be in contact only with the first inner surface S-L1 of the first partition wall layer L1.

The cathode CE may be conductive. The cathode CE may be formed of at least one selected from various conductive materials such as a metal, a transparent conductive oxide (TCO), and a conductive polymer material, for example. In an embodiment, for example, the cathode CE may include silver (Ag), magnesium (Mg), lead (Pb), copper (Cu), or compounds thereof.

In an embodiment of the disclosure, the display element layer DP-OLED may further include a capping pattern CP. The capping pattern CP may be disposed inside the partition wall opening OP-P or the light emitting opening OP-E and disposed on the cathode CE. The capping pattern CP may be patterned by a tip portion defined in the preliminary partition wall PW-I (see FIG. 7F) formed in the display panel manufacturing process. A detailed description thereof will be made below. In another embodiment, the capping pattern CP may be omitted.

The partition wall PW may be disposed on the pixel defining film PDL. The partition wall opening OP-P may be defined in the partition wall PW. The partition wall opening OP-P may correspond to the light emitting opening OP-E and expose at least a portion of the anode AE.

The partition wall PW may include the first partition wall layer L1 and a second partition wall layer L2. The first partition wall layer L1 may be disposed on the pixel defining film PDL, and the second partition wall layer L2 may be disposed on the first partition wall layer L1. In an embodiment, as illustrated in FIG. 5, a thickness of the first partition wall layer L1 may be greater than a thickness of the second partition wall layer L2, but the disclosure is not limited thereto.

The first partition wall layer L1 may include the first inner surface S-L1, and the second partition wall layer L2 may include a second inner surface S-L2. The partition wall opening OP-P may be defined by the first inner surface S-L1 of the first partition wall layer L1 and the second inner surface S-L2 of the second partition wall layer L2. The first inner surface S-L1 of the first partition wall layer L1 and the second inner surface S-L2 of the second partition wall layer L2 may be aligned with each other or on a same plane, that is, collectively form a same continuous surface. A width of the partition wall opening OP-P may be continuous or constant along the first partition wall layer L1 and the second partition wall layer L2. That is, portions of the first partition wall layer L1 and the second partition wall layer L2 may not be recessed as compared to the other portions thereof. The partition wall PW may not be undercut and may not include a tip portion.

The first partition wall layer L1 and the second partition wall layer L2 may include a conductive material. In an embodiment, for example, the conductive material may include a metal, a TCO, or a combination thereof. In an embodiment, for example, the metal includes gold (Au), silver (Ag), aluminium (Al), magnesium (Mg), lithium (Li), molybdenum (Mo), titanium (Ti), copper (Cu), or alloys thereof. The TCO may include an ITO, an indium zinc oxide (IZO), a zinc oxide, an indium oxide, an indium gallium oxide, an indium gallium zinc oxide (IGZO) or an aluminium zinc oxide. In an embodiment of the disclosure, the second partition wall layer L2 may include an inorganic material. In an embodiment, for example, the second partition wall layer L2 may include at least one selected from a silicon oxy nitride (SiON) and a silicon nitride (SiNₓ).

FIG. 5 illustrates an embodiment where each of the first inner surface S-L1 and the second inner surface S-L2 is perpendicular to the upper surface of the pixel defining film PDL, but the disclosure is not limited thereto. In an embodiment, for example, the partition wall PW may have a tapered shape or a reverse tapered shape in a cross section.

The partition wall PW may receive a driving voltage, and accordingly, the cathode CE may be electrically connected to the partition wall PW to receive a driving voltage.

The thin film encapsulation layer TFE may be disposed on the display element layer DP-OLED. The thin film encapsulation layer TFE may include a lower encapsulation inorganic pattern LIL, an encapsulation organic film OL, and an upper encapsulation inorganic film UII,.

The lower encapsulation inorganic pattern LIL may correspond to the light emitting opening OP-E. The lower encapsulation inorganic pattern LIL may be disposed on the cathode CE and may cover the light emitting element ED. The lower encapsulation inorganic pattern LIL may be formed inside the partition wall opening OP-P. In an embodiment, for example, the lower encapsulation inorganic pattern LIL may not be formed on the partition wall PW, but may be formed inside the partition wall opening OP-P. An end of the lower encapsulation inorganic pattern LIL may be in contact with the second inner surface S-L2 of the second partition wall layer L2. That is, on a plane, the lower encapsulation inorganic pattern LIL may not overlap the partition wall PW in the third direction DR3, which may be a thickness direction of the base layer BL.

According to an embodiment of the disclosure, a coupling force of the lower encapsulation inorganic pattern LIL may be improved as the lower encapsulation inorganic pattern LIL is in direct contact with and coupled to the second partition wall layer L2 containing an inorganic material. In such an embodiment, the lower encapsulation inorganic pattern LIL may not be disposed on the partition wall PW. As a result, a sealing capability for protecting the display element layer DP-OLED of the lower encapsulation inorganic pattern LIL may be improved, and pixel defects (dark spots, pixel shrinkage, or the like) caused by foreign substances introduced from a side surface of the lower encapsulation inorganic pattern LIL formed on the partition wall PW may be reduced or eliminated. In such an embodiment, a wet etched area increases in a process of etching the lower encapsulation inorganic pattern LIL, and thus mass productivity (or manufacturing efficiency) of the display panel DP may be improved.

The encapsulation organic film OL may be disposed on the lower encapsulation inorganic pattern LIL. The encapsulation organic film OL may cover the lower encapsulation inorganic pattern LIL and provide a flat upper surface. The encapsulation organic film OL may cover an upper surface U-L2 of the second partition wall layer L2 and an upper surface U-LIL of the lower encapsulation inorganic pattern LIL. The upper encapsulation inorganic film UIL may be disposed on the encapsulation organic film OL.

The lower encapsulation inorganic pattern LIL and the upper encapsulation inorganic film UIL may protect the display element layer DP-OLED from moisture/oxygen, and the encapsulation organic film OL may protect the display element layer DP-OLED from foreign substances such as dust particles.

FIG. 5 illustrates an embodiment where the thin film encapsulation layer TFE includes the lower encapsulation inorganic pattern LIL, the encapsulation organic film OL, and the upper encapsulation inorganic film UIL, but the disclosure is not limited thereto. For example, in an embodiment, the thin film encapsulation layer TFE may further include an inorganic pattern disposed between the lower encapsulation inorganic pattern LIL and the encapsulation organic film OL. In another embodiment, the thin film encapsulation layer TFE may not include the encapsulation organic film OL.

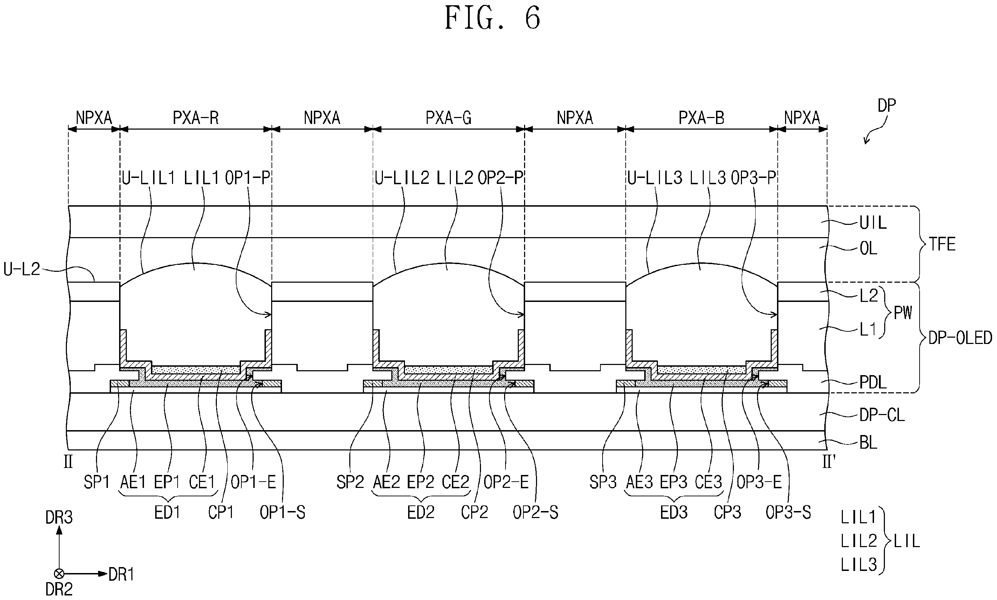

FIG. 6 is a cross-sectional view taken along line II-II' of FIG. 4. FIG. 6 is an enlarged view illustrating a portion including one first light emitting area PXA-R, one second light emitting area PXA-G, and one third light emitting area PXA-B, and the features of the one light emitting area PXA described above with reference to FIG. 5 may be equally applied to the first to third light emitting areas PXA-R, PXA-G, and PXA-B of FIG. 6.

Referring to FIG. 6, an embodiment of the display panel DP may include the base layer BL, the circuit element layer DP-CL, the display element layer DP-OLED, and the thin film encapsulation layer TFE. The display element layer DP-OLED may include light emitting elements ED1, ED2, and ED3, sacrificial patterns SP1, SP2, and SP3, the pixel defining film PDL, and the partition wall PW.

The light emitting elements ED1, ED2, and ED3 may include a first light emitting element ED1, a second light emitting element ED2, and a third light emitting element ED3. The first light emitting element ED1 may include a first anode AE1, a first light emitting pattern EP1, and a first cathode CE1. The second light emitting element ED2 may include a second anode AE2, a second light emitting pattern EP2, and a second cathode CE2. The third light emitting element ED3 may include a third anode AE3, a third light emitting pattern EP3, and a third cathode CE3. The first to third anodes AE1, AE2, and AE3 may be provided as (or defined by) a plurality of patterns. In an embodiment, the first light emitting pattern EP1 may provide (or emit) a red light, the second light emitting pattern EP2 may provide a green light, and the third light emitting pattern EP3 may provide a blue light.

First to third light emitting openings OP1-E, OP2-E, and OP3-E may be defined in the pixel defining film PDL. The first light emitting opening OP1-E may expose at least a portion of the first anode AE1. The second light emitting opening OP2-E may expose at least a portion of the second anode AE2. The third light emitting opening OP3-E may expose at least a portion of the third anode AE3.

In an embodiment, the first light emitting area PXA-R may be defined as an area of an upper surface of the first anode AE1, which is exposed by the first light emitting opening OP1-E. The second light emitting area PXA-G may be defined as an area of an upper surface of the second anode AE2, which is exposed by the second light emitting opening OP2-E. The third light emitting area PXA-B may be defined as an area of an upper surface of the third anode AE3, which is exposed by the third light emitting opening OP3-E.

The sacrificial patterns SP1, SP2, and SP3 may include the first sacrificial pattern SP1, the second sacrificial pattern SP2, and the third sacrificial pattern SP3. The first to third sacrificial patterns SP1, SP2, and SP3 may be arranged on the upper surfaces of the first to third anodes AE1, AE2, and AE3, respectively. First to third sacrificial openings OP1-S, OP2-S, and OP3-S that overlap the first to third light emitting openings OP1-E, OP2-E, and OP3-E may be defined in the first to third sacrificial patterns SP1, SP2, and SP3, respectively.

In an embodiment, first to third partition wall openings OP1-P, OP2-P, and OP3-P that overlap the first to third light emitting openings OP1-E, OP2-E, and OP3-E may be defined in the partition wall PW, respectively. The inner surfaces of the first partition wall layer L1 and the second partition wall layer L2 of each of the first to third partition wall openings OP1-P, OP2-P, and OP3-P may be aligned with each other or on a same plane. That is, the portions of the first partition wall layer L1 and the second partition wall layer L2 may not be recessed as compared to the other portions thereof. The partition wall PW may not be undercut and may not include a tip portion.

The first light emitting pattern EP1 and the first cathode CE1 may be arranged in the first partition wall opening OP1-P and the first light emitting opening OP1-E, the second light emitting pattern EP2 and the second cathode CE2 may be arranged in the second partition wall opening OP2-P and the second light emitting opening OP2-E, and the third light emitting pattern EP3 and the third cathode CE3 may be arranged in the third partition wall opening OP3-P and the third light emitting opening OP3-E. The first to third cathodes CE1, CE2, and CE3 may be disconnected from each other by the partition wall PW to correspond to the first to third light emitting areas PXA-R, PXA-G, and PXA-B.

In an embodiment, the first to third light emitting patterns EP1, EP2, and EP3 and the first to third cathodes CE1, CE2, and CE3 may be physically separated from each other by the tip portion defined in the preliminary partition wall PW-I (see FIG. 7F) formed in the display panel manufacturing process and thus may be formed inside the sacrificial openings OP1-S, OP2-S, and OP3-S, the light emitting openings OP1-E, OP2-E, and OP3-E, or the partition wall openings OP1-P, OP2-P, and OP3-P, respectively.

According to an embodiment of the disclosure, the plurality of first light emitting patterns EP1 may be patterned and deposited in units of pixels by the tip portion defined in the preliminary partition wall PW-I (see FIG. 7F) formed in the display panel manufacturing process. That is, the first light emitting patterns EP1 may be commonly formed using an open mask but may be easily divided in units of pixels by the partition wall PW.

In a case where the first light emitting patterns EP1 are patterned using a fine metal mask (FMM), a support spacer protruding from a conductive partition wall may be desired to be provided to support the FMM. In this case, since the FMM is spaced apart from a base surface, on which the patterning is performed, by a height of the partition wall and the support spacer, implementation in a high resolution may be limited. In this case, as the fine metal mask is in contact with the support spacer, after the patterning process for the first light emitting pattern EP1, foreign substances may remain on the support spacer, and the support spacer may be damaged due to stamping of the mask. Accordingly, a defective display panel may be formed.

According to an embodiment, physical separation between the light emitting elements ED1, ED2, and ED3 may be easily performed by the preliminary partition wall PW-I formed in the display panel manufacturing process. Accordingly, current leakages or driving errors between the adjacent light emitting areas PXA-R, PXA-G, and PXA-B may be effectively prevented, and independent driving for each of the light emitting elements ED1, ED2, and ED3 may be performed.

In such an embodiment, since the plurality of first light emitting patterns EP1 are patterned without using a mask in contact with an inner component inside the display area DA (see FIG. 1B), a defect rate is reduced, and thus the display panel DP having improved process reliability may be provided. As the patterning may be performed even when the separate support spacer protruding from the partition wall PW is not provided, areas of the light emitting areas PXA-R, PXA-G, and PXA-B may be miniaturized, and thus the display panel DP having a high resolution may be provided.

In such an embodiment, in manufacturing a large-area display panel DP, the display panel DP may be provided in which process costs may be reduced as production of a large-area mask is omitted, and process reliability may be improved as the display panel DP is not affected by defects that may occur in the large-area mask. The description of the plurality of first light emitting patterns EP1 may be equally applied to the plurality of second and third light emitting patterns EP2 and EP3.

The thin film encapsulation layer TFE may include lower encapsulation inorganic patterns LIL1, LIL2, and LIL3, the encapsulation organic film OL, and the upper encapsulation inorganic film UIL.

In an embodiment, the lower encapsulation inorganic patterns LIL1, LIL2, and LIL3 may include the first lower encapsulation inorganic pattern LIL1, the second lower encapsulation inorganic pattern LIL2, and the third lower encapsulation inorganic pattern LIL3. The first to third lower encapsulation inorganic patterns LIL1, LIL2, and LIL3 may overlap the first to third light emitting openings OP1-E, OP2-E, and OP3-E, respectively. The first to third lower encapsulation inorganic patterns LIL1, LIL2, and LIL3 may be provided in the form of patterns spaced apart from each other.

The first lower encapsulation inorganic pattern LIL1 may cover the first light emitting element ED1. The first lower encapsulation inorganic pattern LIL1 may be formed inside the first partition wall opening OP1-P. In an embodiment, for example, the first lower encapsulation inorganic pattern LIL1 may not be formed on the partition wall PW corresponding to the first light emitting element ED1 and may be formed inside the first partition wall opening OP1-P. An end (or a side surface) of the first lower encapsulation inorganic pattern LIL1 may be in contact with the second inner surface S-L2 (see FIG. 5) of the second partition wall layer L2.

The second lower encapsulation inorganic pattern LIL2 may cover the second light emitting element ED2. The second lower encapsulation inorganic pattern LIL2 may be formed inside the second partition wall opening OP2-P. In an embodiment, for example, the second lower encapsulation inorganic pattern LIL2 may not be formed on the partition wall PW corresponding to the second light emitting element ED2, but may be formed inside the second partition wall opening OP2-P. An end (or a side surface) of the second lower encapsulation inorganic pattern LIL2 may be in contact with the second inner surface S-L2 (see FIG. 5) of the second partition wall layer L2.

The third lower encapsulation inorganic pattern LIL3 may cover the third light emitting element ED3. The third lower encapsulation inorganic pattern LIL3 may be formed inside the third partition wall opening OP3-P. In an embodiment, for example, the third lower encapsulation inorganic pattern LIL3 may not be formed on the partition wall PW corresponding to the third light emitting element ED3, but may be formed inside the third partition wall opening OP3-P. An end (or a side surface) of the third lower encapsulation inorganic pattern LIL3 may be in contact with the second inner surface S-L2 (see FIG. 5) of the second partition wall layer L2.

The encapsulation organic film OL may be disposed on the first to third lower encapsulation inorganic patterns LIL1, LIL2, and LIL3. The encapsulation organic film OL may cover the first to third lower encapsulation inorganic patterns LIL1, LIL2, and LIL3. In an embodiment, for example, the encapsulation organic film OL may cover the upper surface U-L2 of the second partition wall layer L2 and upper surfaces U-LIL1, U-LIL2, and U-LIL3 of the first to third lower encapsulation inorganic patterns LIL1, LIL2, and LIL3.

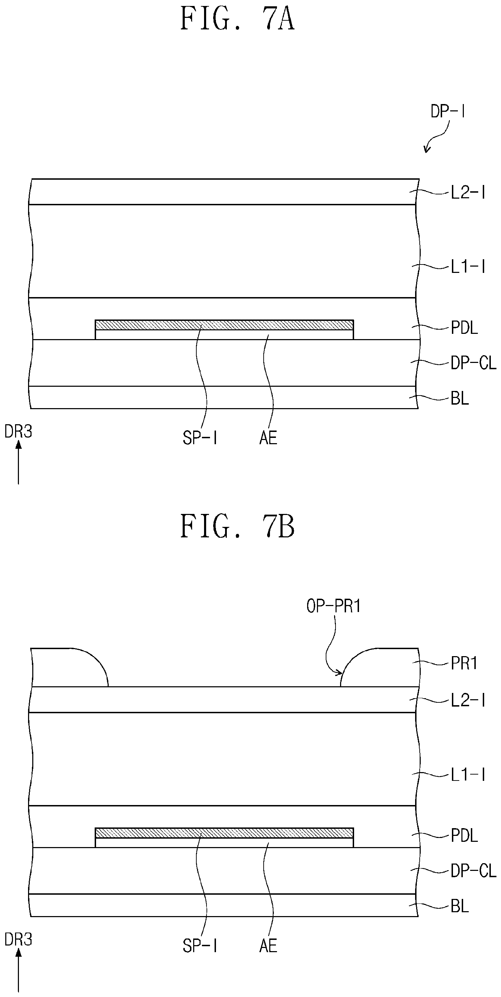

FIGS. 7A to 7L are cross-sectional views illustrating some of operations of a method of manufacturing the display panel according to an embodiment of the disclosure. The same or like elements shown in FIGS. 7A to 7L have been labeled with the same reference characters as used above to describe the embodiments shown in FIGS. 1 to 6, and any repetitive detailed description thereof will hereinafter be omitted or simplified.

An embodiment of a method of forming one light emitting element ED and the lower encapsulation inorganic pattern LIL, the encapsulation organic film OL, and the upper encapsulation inorganic film UIL that cover the light emitting element ED will be described below with reference to FIGS. 7A to 7L. The display panel DP formed through FIGS. 7A to 7L may correspond to the display panel DP of FIG. 5.

Referring to FIG. 7A, an embodiment of the method of manufacturing a display panel includes an operation of providing a preliminary display panel DP-I. The preliminary display panel DP-I provided in an embodiment may include the base layer BL, the circuit element layer DP-CL, the anode AE, a sacrificial layer SP-I, and the pixel defining film PDL, a first preliminary partition wall layer L1-I, and a second preliminary partition wall layer L2-I.

The circuit element layer DP-CL may be formed by a general method of manufacturing a circuit element, in which the insulating layer, the semiconductor layer, and the conductive layer are formed through a coating method or a deposition method, the insulating layer, the semiconductor layer, and the conductive layer are selectively patterned by a photolithography and etching process, and a semiconductor pattern, a conductive pattern, a signal line or the like is formed.

The anode AE and the sacrificial layer SP-I may be formed through the same patterning process. The pixel defining film PDL may be disposed on the base layer BL. The pixel defining film PDL may cover both the anode AE and the sacrificial layer SP-I.

The first preliminary partition wall layer L1-I is provided on the pixel defining film PDL. The first preliminary partition wall layer L1-I may be formed through a process of depositing a conductive material on the pixel defining film PDL. The second preliminary partition wall layer L2-I is provided on the first preliminary partition wall layer L1-I. The second preliminary partition wall layer L2-I may be formed through a process of depositing a conductive material on the first preliminary partition wall layer L1-I.

In an embodiment, the first preliminary partition wall layer L1-I and the second preliminary partition wall layer L2-I may include a conductive material. In an embodiment, for example, the conductive material may include a metal, a TCO, or a combination thereof. In an embodiment, for example, the metal includes gold (Au), silver (Ag), aluminium (Al), magnesium (Mg), lithium (Li), molybdenum (Mo), titanium (Ti), copper (Cu), or alloys thereof. The TCO may include ITO, an IZO, a zinc oxide, an indium oxide, an indium gallium oxide, an IGZO or an aluminium zinc oxide.

In an embodiment of the disclosure, the second preliminary partition wall layer L2-I may include an inorganic material. In an embodiment, for example, the second preliminary partition wall layer L2-I may include at least one selected from a silicon oxy nitride (SiON) and a silicon nitride (SiNₓ). However, the materials of the first preliminary partition wall layer L1-I and the second preliminary partition wall layer L2-I are not limited thereto.

Thereafter, referring to FIG. 7B, an embodiment of the method of manufacturing a display panel may further include an operation of forming a first photoresist layer PR1 on the second preliminary partition wall layer L2-I. The first photoresist layer PR1 may be formed by forming a preliminary photoresist layer on the second preliminary partition wall layer L2-I and then patterning the preliminary photoresist layer using a photo mask. Through the patterning process, a first photo opening OP-PR1 that overlaps the anode AE may be formed in the first photoresist layer PR1.

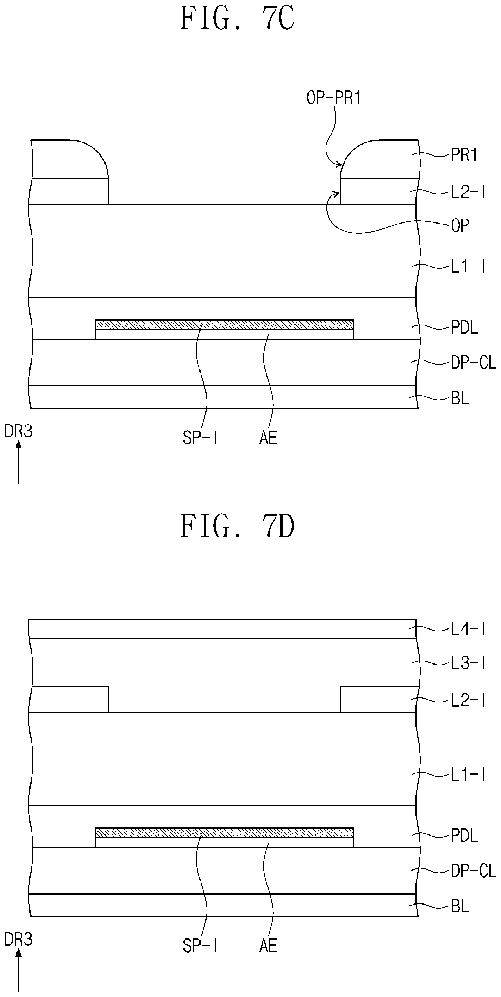

Thereafter, referring to FIG. 7C, an embodiment of the method of manufacturing a display panel may further include an operation of etching a portion of the second preliminary partition wall layer L2-I, which corresponds to the anode AE. In the operation of etching the second preliminary partition wall layer L2-I, the second preliminary partition wall layer L2-I may be dry-etched using the first photoresist layer PR1 as a mask. As a result, a portion of the second preliminary partition wall layer L2-I, which overlaps the first photo opening OP-PR1, may be removed. That is, an opening OP that overlaps the first photo opening OP-PR1 may be formed in the second preliminary partition wall layer L2-I.

Referring to FIG. 7D, an embodiment of the method of manufacturing a display panel further includes an operation of forming a third preliminary partition wall layer L3-I and a fourth preliminary partition wall layer L4-I on the first preliminary partition wall layer L1-I and the second preliminary partition wall layer L2-I after the first photoresist layer PR1 (see FIG. 7C) is removed.

The third preliminary partition wall layer L3-I may be formed on the first preliminary partition wall layer L1-I and the second preliminary partition wall layer L2-I. The fourth preliminary partition wall layer L4-I may be formed on the third preliminary partition wall layer L3-I. The third preliminary partition wall layer L3-I and the fourth preliminary partition wall layer L4-I may be formed through a process of depositing a conductive material. The third preliminary partition wall layer L3-I may include a same material as that of the first preliminary partition wall layer L1-I, and the fourth preliminary partition wall layer L4-I may include a material having an etch rate lower than an etch rate of the first and third preliminary partition wall layers L1-I and L3-I. However, this is illustrative, and the materials of the third and fourth preliminary partition wall layers L3-I and L4-I are not limited to the above example.

Referring to FIGS. 7E and 7F, an embodiment of the method of manufacturing a display panel further includes an operation of forming the preliminary partition wall PW-I including the tip portion and defining a preliminary partition wall opening (or a second preliminary partition wall opening) OP-PI2 by etching the first to fourth preliminary partition wall layers L1-I, L2-I, L3-I, and L4-I. The operation of forming the preliminary partition wall PW-I may include an operation of forming a first preliminary partition wall opening OP-PI1 by etching the first preliminary partition wall layer L1-I, the third preliminary partition wall layer L3-I, and the fourth preliminary partition wall layer L4-I and an operation of forming the second preliminary partition wall opening OP-PI2 by etching the first to third preliminary partition wall layers L1-I, L2-I, and L3-I.

First, as illustrated in FIG. 7E, an embodiment of the method of manufacturing a display panel may include an operation of forming a second photoresist layer PR2 on the fourth preliminary partition wall layer L4-I. The second photoresist layer PR2 may be formed by forming a preliminary photoresist layer on the fourth preliminary partition wall layer L4-I and then patterning the preliminary photoresist layer using a photo mask. Through the patterning process, a second photo opening OP-PR2 that overlaps the anode AE may be formed in the second photoresist layer PR2.

The operation of forming the first preliminary partition wall opening OP-PI1 by etching the first preliminary partition wall layer L1-I, the third preliminary partition wall layer L3-I, and the fourth preliminary partition wall layer L4-I may include an operation of dry etching (hereinafter, primarily dry etching) the first preliminary partition wall layer L1-I, the third preliminary partition wall layer L3-I, and the fourth preliminary partition wall layer L4-I using the second photoresist layer PR2 as a mask. The first preliminary partition wall opening OP-PI1 may be formed by etching portions of the first preliminary partition wall layer L1-I, the third preliminary partition wall layer L3-I, and the fourth preliminary partition wall layer L4-I, which overlap the second photo opening OP-PR2.

The primary dry etching process according to an embodiment may be performed in an etching environment in which an etching selection ratio between the first preliminary partition wall layer L1-I, the third preliminary partition wall layer L3-I, and the fourth preliminary partition wall layer L4-I is substantially the same as each other. Accordingly, an inner surface S-L1-I1 of the first preliminary partition wall layer L1-I, an inner surface S-L3-I1 of the third preliminary partition wall layer L3-I, and an inner surface S-L4-I1 of the fourth preliminary partition wall layer L4-I, which define the first preliminary partition wall opening OP-PI1, may be substantially aligned with each other or on a same plane.

Thereafter, referring to FIG. 7F, the operation of forming the second preliminary partition wall opening OP-PI2 by etching the first to third preliminary partition wall layers L1-I, L2-I, and L3-I may include an operation of wet etching (hereinafter, secondarily wet etching) the first to third preliminary partition wall layers L1-I, L2-I, and L3-I using the second photoresist layer PR2 as a mask. The second preliminary partition wall opening OP-PI2 may be formed by etching portions of the first to third preliminary partition wall layers L1-I, L2-I, and L3-I, which overlap the second photo opening OP-PR2. The second preliminary partition wall opening OP-PI2 may be referred to as the preliminary partition wall opening OP-PI2. The first to fourth preliminary partition wall layers L1-I, L2-I, L3-I, and L4-I after the secondary wet etching process may form the preliminary partition wall PW-I.

The secondary wet etching process in an embodiment may be performed in an environment in which the etching selection ratio of the first to third preliminary partition wall layers L1-I, L2-I, and L3-I with the fourth preliminary partition wall layer L4-I is high. Accordingly, inner surfaces S-L1-I2, S-L2-I2, S-L3-I2, and S-L4-I2 of the partition wall PW, which define the second preliminary partition wall opening OP-PI2, may have an undercut shape on a cross section. In detail, as an etch rate of the first to third preliminary partition wall layers L1-I, L2-I, and L3-I with respect to an etching solution is greater than an etch rate of the fourth preliminary partition wall layer L4-I, the first to third preliminary partition wall layers L1-I, L2-I, and L3-I may be mainly etched. Accordingly, the inner surfaces S-L1-I2, S-L2-I2, and S-L3-I2 of the first to third preliminary partition wall layers L1-I, L2-I, and L3-I may be further recessed inward (or towards a center of a corresponding second preliminary partition wall opening OP-PI2) as compared to the inner surface S-L4-I2 of the fourth preliminary partition wall layer L4-I. A tip portion may be formed in the preliminary partition wall PW-I by a portion of the fourth preliminary partition wall layer L4-I, which protrudes further from the first to third preliminary partition wall layers L1-I, L2-I, and L3-I. The etched fourth preliminary partition wall layer L4-I may include the tip portion.

The second preliminary partition wall opening OP-PI2 may include a first area A1 and a second area A2 that are sequentially formed in a thickness direction (i.e., the third direction DR3). The first area A1 may be defined by the inner surface S-L1-I2 of the first preliminary partition wall layer L1-I, the inner surface S-L2-I2 of the second preliminary partition wall layer L2-I, and the inner surface S-L3-I2 of the third preliminary partition wall layer L3-I, and the second area A2 may be defined by the inner surface S-L4-I2 of the fourth preliminary partition wall layer L4-I. A width of the second area A2 in one direction may be smaller than a width of the first area A1 in the one direction.

In an embodiment, the operation of forming the second preliminary partition wall opening OP-PI2 of FIGS. 7E and 7F may include an operation of simultaneously forming the partition wall openings OP1-P, OP2-P, and OP3-P (see FIG. 6) corresponding to the first to third light emitting areas PXA-R, PXA-G, and PXA-B, respectively (see FIG. 6). However, the disclosure is not limited to the above example, and in an embodiment, the operation of forming only the first partition wall opening OP1-P corresponding to the first light emitting area PXA-R takes place. In an embodiment, for example, the first partition wall opening OP1-P corresponding to the first light emitting area PXA-R may be formed, the first light emitting element ED 1 (see FIG. 6) may be formed through a subsequent process, and then the second partition wall opening OP2-P corresponding to the second light emitting area PXA-G may be formed. In such an embodiment, the second light emitting element ED2 (see FIG. 6) may be formed through a subsequent process, and the third partition wall opening OP3-P corresponding to the third light emitting area PXA-B may be formed.

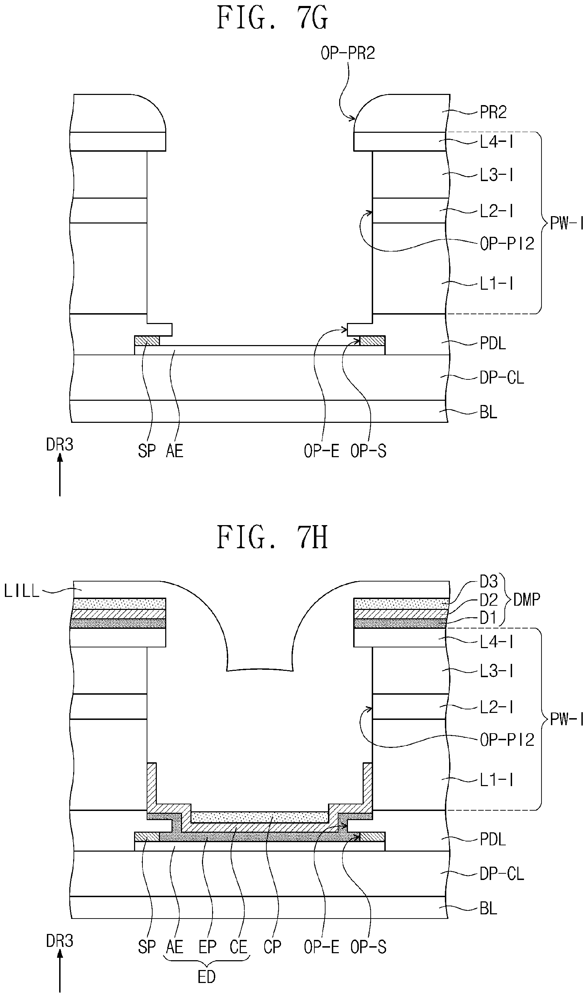

Thereafter, referring to FIG. 7G, an embodiment of the method of manufacturing a display panel may further include an operation of etching the pixel defining film PDL and an operation of etching the sacrificial layer SP-I (see FIG. 7D). The process of etching the pixel defining film PDL may be performed by a dry etching method using the second photoresist layer PR2 and the fourth preliminary partition wall layer L4-I as a mask. The light emitting opening OP-E corresponding to the second preliminary partition wall opening OP-PI2 may be formed in the pixel defining film PDL.

The process of etching the sacrificial layer SP-I may be performed by a wet etching method using the second photoresist layer PR2 and the fourth preliminary partition wall layer L4-I as a mask. The sacrificial opening OP-S that overlaps the light emitting opening OP-E may be formed in the sacrificial pattern SP formed by etching the sacrificial layer SP-I. At least a portion of the anode AE may be exposed from the sacrificial pattern SP and the pixel defining film PDL through the sacrificial opening OP-S and the light emitting opening OP-E.

The process of etching the sacrificial layer SP-I may be performed in an environment in which an etch selection ratio between the sacrificial layer SP and the anode AE is high, and therefore, the anode AE may be effectively prevented from being etched together. That is, the sacrificial layer SP-I having an etch rate that is greater than that of the anode AE is disposed between the pixel defining film PDL and the anode AE, and thus the anode AE may be effectively prevented from being etched and damaged together during the etching process.

Referring to FIG. 7H, an embodiment of the method of manufacturing a display panel further includes an operation of forming the light emitting pattern EP and the cathode CE on the anode AE after removing the second photoresist layer PR2 (see FIG. 7F). The operation of forming the light emitting pattern EP and the cathode CE on the anode AE may include an operation of forming, on the partition wall PW, a first dummy pattern D1 including a same material as that of the light emitting pattern EP and a second dummy pattern D2 including a same material as that of the cathode CE.

First, referring to FIG. 7H, the operation of forming the light emitting pattern EP and the cathode CE may be performed through a deposition process. In an embodiment, the operation of forming the light emitting pattern EP may include a thermal evaporation process, and the operation of forming the cathode CE may include a sputtering process.

The light emitting pattern EP is formed on the anode AE. In the operation of forming the light emitting pattern EP, the light emitting pattern EP may be separated from each other by the tip portion formed in the preliminary partition wall PW-I and may be disposed inside the light emitting opening OP-E and the sacrificial opening OP-S. However, this is illustrative, and the light emitting pattern EP may be disposed in the light emitting opening OP-E, the sacrificial opening OP-S, or the preliminary partition wall opening OP-PI2.

In the operation of forming the light emitting pattern EP, the first dummy pattern D1 spaced apart from the light emitting pattern EP may be formed on the preliminary partition wall PW-I together. The first dummy pattern D1 may include an organic material. In an embodiment, for example, the first dummy pattern D1 may include the same material as that of the light emitting pattern EP. The first dummy pattern D1 together with the light emitting pattern EP may be simultaneously formed through a same process and formed separately from the light emitting pattern EP by the undercut shape of the preliminary partition wall PW-I.

The cathode CE may be formed on the light emitting pattern EP. In the operation of forming the cathode CE, the cathode CE may be separated from each other by the tip portion formed in the preliminary partition wall PW-I and may be disposed inside the light emitting opening OP-E and the preliminary partition wall opening OP-PI2. However, this is illustrative, and the cathode CE may be disposed inside the preliminary partition wall opening OP-PI2. The cathode CE may be provided at a higher input angle than that of the light emitting pattern EP, and the cathode CE may be formed in contact with the inner surface S-L1-I2 of the first preliminary partition wall layer L1-I. The anode AE, the light emitting pattern EP, and the cathode CE may constitute the light emitting element ED.

In the operation of forming the cathode CE, the second dummy pattern D2 that is spaced apart from the cathode CE may be together formed on the preliminary partition wall PW-I. The second dummy pattern D2 may include a conductive material. In an embodiment, for example, the second dummy pattern D2 may include a same material as that of the cathode CE. The second dummy pattern D2 may be simultaneously formed through a same process together with the cathode CE and formed separately from the cathode CE by the undercut shape of the preliminary partition wall PW-I.

The first dummy pattern D1 and the second dummy pattern D2 may be sequentially stacked in the third direction DR3 on an upper surface of the preliminary partition wall PW-I. The first dummy pattern D1 and the second dummy pattern D2 may form a dummy pattern DMP.

In an embodiment of the disclosure, the method of manufacturing a display panel may further include an operation of forming the capping pattern CP. The operation of forming the capping pattern CP may include a thermal evaporation process. The capping pattern CP may be formed on the cathode CE. In the operation of forming the capping pattern CP, the capping pattern CP may be separated from each other by the tip portion formed in the preliminary partition wall PW-I and disposed inside the preliminary partition wall opening OP-PI2 or the light emitting opening OP-E.

In the operation of forming the capping pattern CP, a third dummy pattern D3 that is spaced apart from the capping pattern CP may be together formed on the preliminary partition wall PW-I. The third dummy pattern D3 may include a conductive material. In an embodiment, for example, the third dummy pattern D3 may include the same material as that of the capping pattern CP. The third dummy pattern D3 may be simultaneously formed through a same process together with the capping pattern CP and formed separately from the capping pattern CP by the undercut shape of the preliminary partition wall PW-I. In this case, the dummy pattern DMP may include the first dummy pattern D1, the second dummy pattern D2, and the third dummy pattern D3.

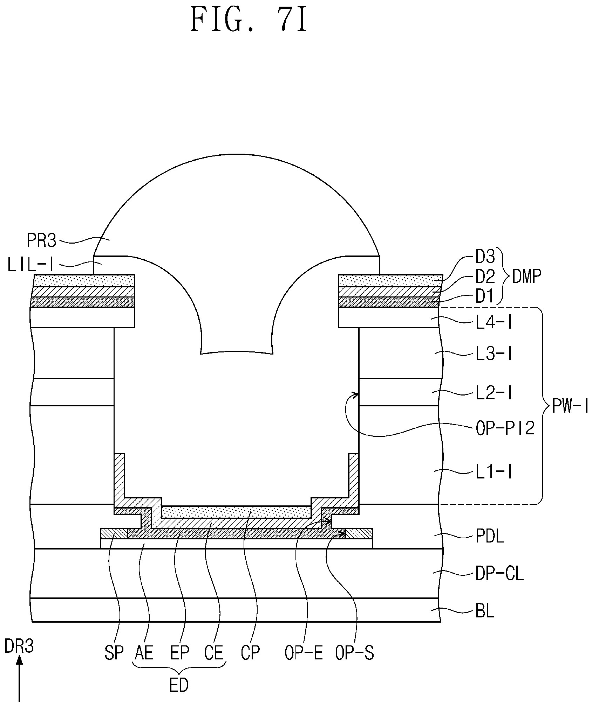

Referring to FIGS. 7H to 7I, an embodiment of the method of manufacturing a display panel further includes an operation of forming a preliminary lower encapsulation inorganic pattern LIL-I on the cathode CE. The operation of forming the preliminary lower encapsulation inorganic pattern LIL-I on the cathode CE may include an operation of forming a lower encapsulation inorganic layer LILL that covers the cathode CE and the preliminary partition wall PW-I and an operation of etching a portion of the lower encapsulation inorganic layer LILL, which does not overlap the anode AE. Hereinafter, the operation of forming the lower encapsulation inorganic layer LILL will be described with reference to FIG. 7H, and the operation of etching the portion of the lower encapsulation inorganic layer LILL, which does not overlap the anode AE, will be described with reference to FIG. 7I.

First, referring to FIG. 7H, the operation of forming the lower encapsulation inorganic layer LILL that covers the cathode CE and the preliminary partition wall PW-I may include a deposition process. In an embodiment, the lower encapsulation inorganic layer LILL may be formed through a chemical vapor deposition (CVD) process. The lower encapsulation inorganic layer LILL may be formed to cover the cathode CE and the preliminary partition wall PW-I.

Thereafter, referring to FIG. 7I, an embodiment of the method of manufacturing a display panel may further include an operation of forming a third photoresist layer PR3. In the operation of forming the third photoresist layer PR3, the third photoresist layer PR3 may be formed by forming a preliminary photoresist layer, and then patterning the preliminary photoresist layer using a photo mask. Through the patterning process, the third photoresist layer PR3 may be formed in a pattern shape that corresponds to the light emitting opening OP-E.

In the operation of etching the portion of the lower encapsulation inorganic layer LILL, which does not overlap the anode AE, the lower encapsulation inorganic layer LILL may be dry-etched using the third photoresist layer PR3 as a mask. The lower encapsulation inorganic layer LILL may be patterned in a way such that the portion of the lower encapsulation inorganic layer LILL, which does not overlap the corresponding anode AE, is removed. The preliminary lower encapsulation inorganic pattern LIL-I that overlaps the anode AE may be formed from the patterned lower encapsulation inorganic layer LILL.

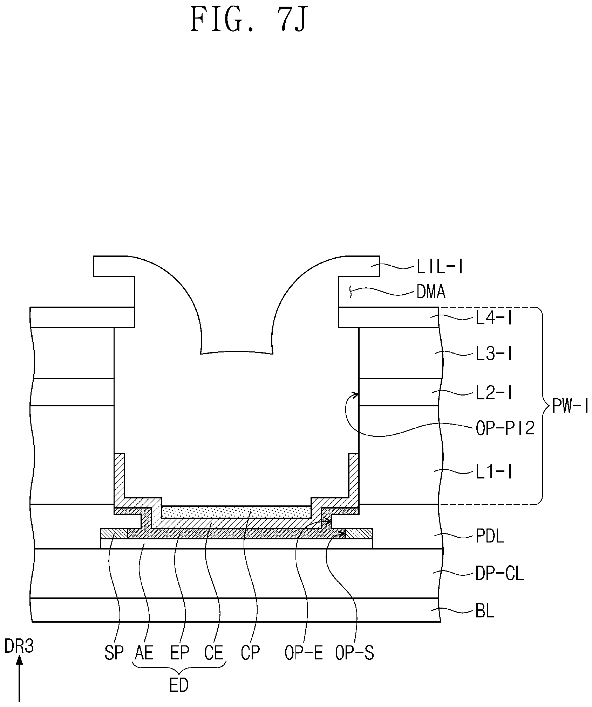

Thereafter, referring to FIG. 7J, an embodiment of the method of manufacturing a display panel may further include an operation of removing the dummy pattern DMP (see FIG. 7I). The operation of removing the dummy pattern DMP may include an operation of wet etching the first dummy pattern D1 (see FIG. 7I), the second dummy pattern D2 (see FIG. 7I), and the third dummy pattern D3 (see FIG. 7I) formed on the preliminary partition wall PW-I. An area from which the dummy pattern DMP is removed may be defined as a dummy area DMA. That is, the dummy area DMA may be formed between the preliminary partition wall PW-I and the preliminary lower encapsulation inorganic pattern LIL-I on a cross section.

After the preliminary lower encapsulation inorganic pattern LIL-I is formed, an operation of forming the preliminary partition wall opening OP-PI2 or the light emitting opening OP-E, which correspond to light emitting areas emitting lights having different colors, in the preliminary partition wall PW-I and the pixel defining film PDL, an operation of forming the light emitting elements ED that provide lights having different colors, and an operation of forming the preliminary lower encapsulation inorganic pattern LIL-I that covers the light emitting elements ED that provide lights having different colors may be further performed. In an embodiment, for example, after the preliminary lower encapsulation inorganic pattern LIL-I that corresponds to the first anode AE1 (see FIG. 6) is formed, the preliminary partition wall opening OP-PI2, the light emitting opening OP2-E (see FIG. 6), the second light emitting element ED2 (see FIG. 6), and the preliminary lower encapsulation inorganic pattern LIL-I that correspond to the second anode AE2 (see FIG. 6) may be formed. Further, after the preliminary lower encapsulation inorganic pattern LIL-I that corresponds to the second anode AE2 is formed, the preliminary partition wall opening OP-PI2, the light emitting opening OP3-E (see FIG. 6), the third light emitting element ED3 (see FIG. 6), and the preliminary lower encapsulation inorganic pattern LIL-I that correspond to the third anode AE3 (see FIG. 6) may be formed. Therefore, the first to third light emitting elements ED1, ED2, and ED3 that correspond to the plurality of light emitting areas PXA-R, PXA-G, and PXA-B illustrated in FIG. 6 and the preliminary lower encapsulation inorganic patterns LIL-I that correspond to the first to third light emitting elements ED1, ED2, and ED3 may be formed.

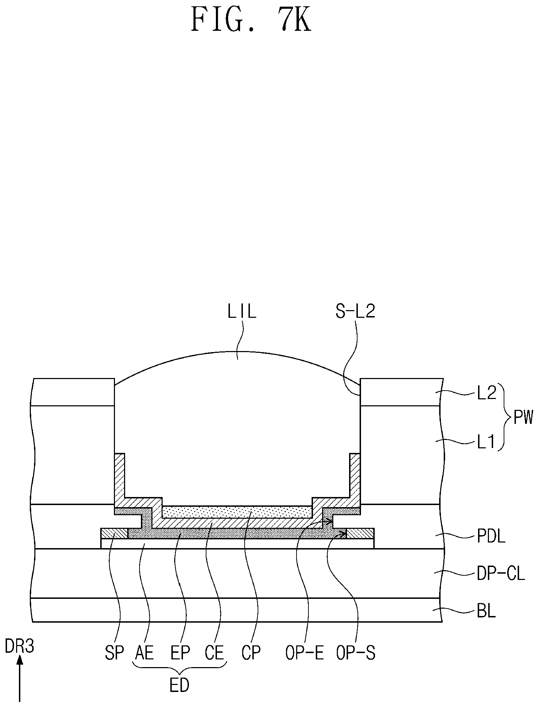

Thereafter, referring to FIG. 7K, an embodiment of the method of manufacturing a display panel further includes an operation of forming the partition wall PW and the lower encapsulation inorganic pattern LIL by etching the preliminary lower encapsulation inorganic pattern LIL-I (see FIG. 7J), the third preliminary partition wall layer L3-I (see FIG. 7J), and the fourth preliminary partition wall layer L4-I (see FIG 7J).

The operation of forming the partition wall PW and the lower encapsulation inorganic pattern LIL by etching the preliminary lower encapsulation inorganic pattern LIL-I, the third preliminary partition wall layer L3-I, and the fourth preliminary partition wall layer L4-I may include an operation of etching the third preliminary partition wall layer L3-I and the fourth preliminary partition wall layer L4-I and an operation of forming the first partition wall layer L1 through the first preliminary partition wall layer L1-I and forming the second partition wall layer L2 through the second preliminary partition wall layer L2-I.

The operation of etching the third preliminary partition wall layer L3-I and the fourth preliminary partition wall layer L4-I may be performed by a dry etching process and a wet etching process. The third preliminary partition wall layer L3-I and the fourth preliminary partition wall layer L4-I that are subjected to the etching process may be removed. The remaining first preliminary partition wall layer L1-I may form the first partition wall layer L1, and the second preliminary partition wall layer L2-I may form the second partition wall layer L2. The first partition wall layer L1 and the second partition wall layer L2 may form the partition wall PW. As the fourth preliminary partition wall layer L4-I including the tip portion is removed, the partition wall PW may not be undercut and may not include the tip portion.

Further, the operation of forming the partition wall PW and the lower encapsulation inorganic pattern LIL by etching the preliminary lower encapsulation inorganic pattern LIL-I, the third preliminary partition wall layer L3-I, and the fourth preliminary partition wall layer L4-I may include an operation of etching the preliminary lower encapsulation inorganic pattern LIL-I that overlaps the third preliminary partition wall layer L3-I and the fourth preliminary partition wall layer L4-I and an operation of forming the lower encapsulation inorganic pattern LIL of which an end is in contact with the second inner surface S-L2 of the second partition wall layer L2.

The operation of etching the preliminary lower encapsulation inorganic pattern LIL-I that overlaps the third preliminary partition wall layer L3-I and the fourth preliminary partition wall layer L4-I may be performed through a same process as that of the above-described operation of etching the third preliminary partition wall layer L3-I and the fourth preliminary partition wall layer L4-I at the same time. In an embodiment, for example, the operation of etching the preliminary lower encapsulation inorganic pattern LIL-I may be performed through a dry etching process and a wet etching process. A portion of the preliminary lower encapsulation inorganic pattern LIL-I, which is subjected to the etching process, may be removed. A portion of the preliminary lower encapsulation inorganic pattern LIL-I, which is formed on the preliminary partition wall PW-I, and portions of the preliminary lower encapsulation inorganic pattern LIL-I, which overlap inner surfaces of the third preliminary partition wall layer L3-I and the fourth preliminary partition wall layer L4-I, may be removed. The remaining preliminary lower encapsulation inorganic pattern LIL-I may form the lower encapsulation inorganic pattern LIL, and an end of the lower encapsulation inorganic pattern LIL may be in contact with the inner surface S-L2 of the second partition wall layer L2.

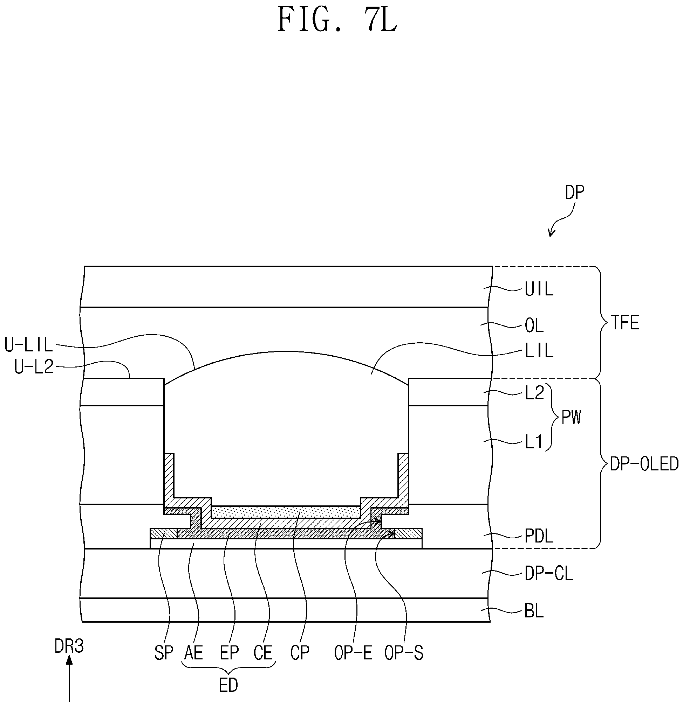

Thereafter, referring to FIG. 7L, an embodiment of the method of manufacturing a display panel may further include an operation of completing the display panel DP by forming the encapsulation organic film OL and the upper encapsulation inorganic film UTL. The encapsulation organic film OL may be formed by applying an organic material in an inkjet method, but the disclosure is not limited thereto. The encapsulation organic film OL may cover the lower encapsulation inorganic pattern LIL and provide a flat upper surface. The encapsulation organic film OL may cover the upper surface U-L2 of the second partition wall layer L2 and the upper surface U-LIL of the lower encapsulation inorganic pattern LIL. Thereafter, the upper encapsulation inorganic film UIL may be formed by depositing an inorganic material. Therefore, the display panel DP including the base layer BL, the circuit element layer DP-CL, the display element layer DP-OLED, and the thin film encapsulation Layer TFE may be formed.

According to embodiments of the disclosure, as described above, a lower encapsulation inorganic pattern is in direct contact with and coupled to a second partition wall layer including an inorganic material, and thus a coupling force of the lower encapsulation inorganic pattern may be improved. In such embodiments, the lower encapsulation inorganic pattern may not be disposed on a partition wall. As a result, a sealing capability for protecting a display element layer of the lower encapsulation inorganic pattern may be improved, and pixel defects (dark spots, pixel shrinkage, and the like) caused by foreign substances introduced from a side surface of the lower encapsulation inorganic pattern formed on the partition wall may be reduced or eliminated. In such embodiments, a wet etched area increases in a process of etching the lower encapsulation inorganic pattern, and thus mass productivity of the display panel may be improved.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display panel comprising:
a base layer;
a pixel defining film disposed on the base layer, wherein a light emitting opening is defined in the pixel defining film;
a partition wall including a first partition wall layer disposed on the pixel defining film and a second partition wall layer disposed on the first partition wall layer, wherein a partition wall opening is defined in the partition wall to overlap the light emitting opening; and
a light emitting element including an anode, an intermediate layer, and a cathode in contact with the partition wall, wherein at least a portion of the light emitting element is disposed inside the partition wall opening,
wherein a first inner surface of the first partition wall layer and a second inner surface of the second partition wall layer are aligned with each other.

2. The display panel of claim 1, wherein the second partition wall layer includes an inorganic material.

3. The display panel of claim 1 or claim 2, wherein the second partition wall layer includes at least one selected from SiON and SiNₓ.

4. The display panel of any one of claims 1 to 3, further comprising:
a plurality of light emitting areas from which lights provided from the light emitting element are emitted,
wherein the cathode is disconnected by the partition wall to correspond to the plurality of light emitting areas.

5. The display panel of any one of claims 1 to 4, further comprising:
a lower encapsulation inorganic pattern covering the light emitting element,
wherein the lower encapsulation inorganic pattern is disposed inside the partition wall opening.

6. The display panel of claim 5, wherein a side surface of the lower encapsulation inorganic pattern is in contact with the second inner surface of the second partition wall layer.

7. The display panel of claim 5 or claim 6, further comprising:
an encapsulation organic film disposed on the lower encapsulation inorganic pattern,
wherein the encapsulation organic film covers an upper surface of the second partition wall layer and an upper surface of the lower encapsulation inorganic pattern.

8. The display panel of any one of claims 1 to 7, wherein:
(i) the cathode extends along the first inner surface of the first partition wall layer, and
an end portion of the cathode is in contact with the first partition wall layer; and/or
(ii) a width of the partition wall opening is constant along the first partition wall layer and the second partition wall layer.

9. A method of manufacturing a display panel, the method comprising:
providing a preliminary display panel in which a base layer, an anode, a pixel defining film, a first preliminary partition wall layer, and a second preliminary partition wall layer are sequentially laminated;
forming a third preliminary partition wall layer and a fourth preliminary partition wall layer on the first preliminary partition wall layer and the second preliminary partition wall layer;
forming a preliminary partition wall including a tip portion and defining a preliminary partition wall opening by etching the first to fourth preliminary partition wall layers;
forming a light emitting pattern and a cathode on the anode;
forming a preliminary lower encapsulation inorganic pattern on the cathode; and
forming a partition wall and a lower encapsulation inorganic pattern by etching the preliminary lower encapsulation inorganic pattern, the third preliminary partition wall layer, and the fourth preliminary partition wall layer.

10. The method of claim 9, further comprising:
etching a portion of the second preliminary partition wall layer, which corresponds to the anode.

11. The method of claim 9 or claim 10, wherein the forming the preliminary partition wall including the tip portion and defining the preliminary partition wall opening by etching the first to fourth preliminary partition wall layers includes:
forming a first preliminary partition wall opening by etching the first preliminary partition wall layer, the third preliminary partition wall layer, and the fourth preliminary partition wall layer; and
forming a second preliminary partition wall opening by etching the first to third preliminary partition wall layers, optionally wherein the second preliminary partition wall opening includes:
a first area defined by an inner surface of the first preliminary partition wall layer, an inner surface of the second preliminary partition wall layer, and an inner surface of the third preliminary partition wall layer; and
a second area defined by an inner surface of the fourth preliminary partition wall layer, and
a width of the second area is less than a width of the first area.

12. The method of any one of claims 9 to 11, wherein an etched fourth preliminary partition wall layer defines the tip portion.

13. The method of any one of claims 9 to 12, wherein the forming the light emitting pattern and the cathode on the anode includes:
forming, on the preliminary partition wall, a first dummy pattern including a same material as a material of the light emitting pattern and a second dummy pattern including a same material as a material of the cathode.

14. The method of claim 13, wherein:
(i) the forming the preliminary lower encapsulation inorganic pattern on the cathode includes:
forming a lower encapsulation inorganic layer to cover the cathode and the preliminary partition wall; and
etching a portion of the lower encapsulation inorganic layer, which does not overlap the anode; and/or
(ii) the method further comprises:
etching the first dummy pattern and the second dummy pattern.

15. The method of any one of claims 9 to 14, wherein the forming the partition wall and the lower encapsulation inorganic pattern by etching the preliminary lower encapsulation inorganic pattern, the third preliminary partition wall layer, and the fourth preliminary partition wall layer includes:
etching the third preliminary partition wall layer and the fourth preliminary partition wall layer,
wherein a first partition wall layer included in the partition wall is formed from the first preliminary partition wall layer and a second partition wall layer included in the partition wall is formed from the second preliminary partition wall layer, optionally wherein the forming the partition wall and the lower encapsulation inorganic pattern by etching the preliminary lower encapsulation inorganic pattern, the third preliminary partition wall layer, and the fourth preliminary partition wall layer further includes:
etching the preliminary lower encapsulation inorganic pattern overlapping the third preliminary partition wall layer and the fourth preliminary partition wall layer,
wherein a side surface of the lower encapsulation inorganic pattern is in contact with an inner surface of the second partition wall layer.
